# EUROPEAN PATENT SPECIFICATION

(11) **EP 1 471 541 B1**
(45) Date of publication and mention of the grant of the patent: **19.10.2016**
(21) Application number: 03734847.1
(22) Date of filing: 27.01.2003
(51) Int. Cl.: C03C 17/00, C03C 17/34, C23C 16/54, H01L 31/18, C03C 17/245, C23C 16/40

(54) **GLASS SUBSTRATE COATED WITH A TRANSPARENT CONDUCTIVE FILM AND PHOTOELECTRIC CONVERSION DEVICE INCLUDING SAID GLASS SUBSTRATE**
GLASSUBSTRAT MIT EINEM TRANSPARENTEN LEITFÄHIGEN FILM UND FOTOELEKTRISCHE UMSETZUNGGERÄT MIT DEM GLASSUBSTRAT
SUBSTRAT DE VERRE REVETU D'UN FILM CONDUCTEUR TRANSPARENT ET UNITE DE CONVERSION PHOTOELECTRIQUE COMPRENANT LEDIT SUBSTRAT DE VERRE

(30) Priority: 28.01.2002 JP 2002018365
(43) Date of publication of application: 27.10.2004
(73) Proprietor: Nippon Sheet Glass Company, Limited, Minato-ku Tokyo 108-6321 (JP); KANEKA CORPORATION, Osaka (JP)
(72) Inventor: Fujisawa, Akira, Osaka-shi, Osaka 541-8559 (JP); Kiyohara, Koichiro, Osaka-shi, Osaka 541-8559 (JP); Hirata, Masahiro, Osaka-shi, Osaka 541-8559 (JP); Ichiki, Kiyotaka, Osaka-shi, Osaka 541-8559 (JP); Sawada, Toru, Uji-shi, Kyoto 611-0025 (JP)
(74) Representative: Lees, Gregory Alexander
(86) International application number: PCT/JP2003/000707
(87) International publication number: WO 2003/065386

(56) References cited:
- EP-A1- 0 782 975
- EP-A2- 0 983 972
- JP-A- 62 191 446
- JP-A- 63 242 947
- JP-A- 2001 035 262
- JP-A- 2001 035 262
- JP-A- 2001 039 738
- JP-A- 2001 039 738
- JP-B2- 5 069 241
- US-A- 4 265 974
- US-A- 4 590 096
- US-A- 4 590 096
- US-A- 5 401 305

## Description

The present invention relates to methods for forming transparent conductive films that are used for photoelectric conversion devices, such as solar cells. Moreover, the present invention relates to glass substrates provided with a transparent conductive film formed with those methods, as well as photoelectric conversion devices using the same.

Many types of thin-film photoelectric conversion devices have been researched and developed, and in the most common configuration, a transparent conductive film whose principal component is tin oxide, a thin-film silicon layer serving as the photoelectric conversion layer, and a rear electrode made of aluminum are formed in that order on a transparent substrate, such as a glass sheet or the like. In this configuration, a transparent conductive film is desired that has a high transmittance of visible light, in order to guide more light to the photoelectric conversion layer, and that has a high conductance (low resistance), in order to keep the internal resistance of the solar cell low.

As the transparent conductive film, films whose principal component is tin oxide doped with fluorine are currently mainstream. Such films have better chemical stability, such as plasma resistance, than films of indium oxide doped with tin (ITO), and are also superior with regard to the fact that they suffer little degradation during the film deposition of the photoelectric conversion layer (thin-film silicon layer) by plasma CVD (chemical vapor deposition). Doping with fluorine reduces the resistance, but in order to function properly as electrodes, a certain thickness is necessary. Consequently, transparent electrode films are preferable in which the absorptivity per unit thickness, that is, the absorption coefficient is as small as possible.

A transparent electrode film provided with these preferable properties has been disclosed in JP 2001-35262A. This publication discloses, in a process of manufacturing a glass sheet by the float process, a method for depositing a transparent electrode film by CVD taking organic tin such as dimethyltin dichloride as the raw material in a bath that is filled with a non-oxidizing atmosphere of nitrogen and hydrogen, and molten tin.

Moreover, JP 2000-313960A discloses a CVD process in which nitrogen is taken as the carrier gas and tin tetrachloride, water vapor and hydrogen bromide are applied to the surface of a glass sheet that has been heated to about 500°C.

However, in the method for manufacturing a transparent conductive film according to JP 2001-35262A, consideration is given to the concentration of fluorine and carbon, and efforts are made to keep their concentration within a predetermined range in order to reduce the absorption coefficient. When the concentration of fluorine is too large, then there is also absorption in the visible light region, so that considering only the absorption coefficient of the transparent conductive film, it would be ideal to include no fluorine at all. However, fluorine is a functional component that reduces the resistance of the transparent conductive film, so that a certain amount needs to be included. On the other hand, carbon inevitably remains in the transparent conductive film since it is included in the raw material, and when its content becomes high, then the absorption at wavelengths of 400 to 500 nm becomes large, and the absorption coefficient increases. Consequently, for the transparent conductive film, it would be ideal to contain a small amount of fluorine and contain almost no carbon.

In JP 2000-313960A, tin tetrachloride is used as the tin raw material, and the other raw materials include no organic substances, so that it seems that the transparent conductive film formed with the method of this publication contains no carbon. Therefore, it can be deduced that the absorption coefficient of this transparent conductive film is sufficiently low. Moreover, as stated in this publication, inorganic tin raw materials such as tin tetrachloride are highly reactive, so that the film deposition speed can be maintained even when the temperature of the reaction system and in particular the surface temperature of the glass sheet is relatively low. That is to say, if an inorganic gas raw material is used, the heating of the glass substrate can be kept at a low level while maintaining the film deposition speed, which means that as a result, there is the effect that the film deposition costs can be reduced, and deformation of the glass substrate due to excessive heating can be prevented. Thus, it seems that if an inorganic tin raw material is used in the CVD process, then a transparent conductive film whose absorption coefficient and deposition costs are low can be easily obtained.

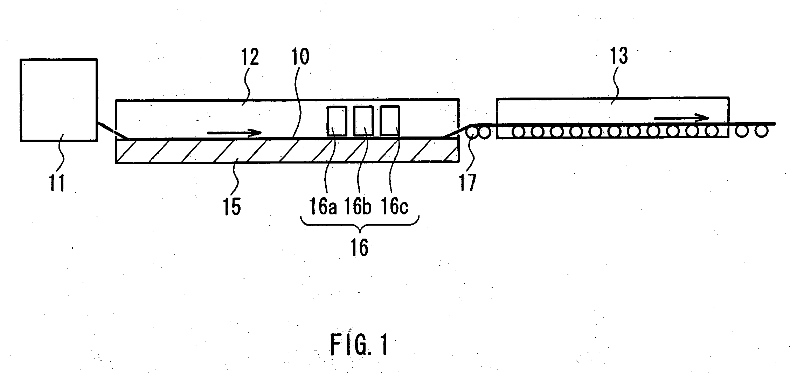

Now, when an inorganic tin raw material is used in a high-temperature reaction system, defects may be formed in the transparent conductive film. For example, in some apparatuses for manufacturing glass sheets by the float process shown in Fig. 1, raw material gas including tin raw material is blown from coaters 16 in a bath 12 (referred to as "shaping bath" in the following) filled with molten tin 15 that is provided to shape molten glass that has been discharged from a glass melting furnace 11 into a glass ribbon 10 of adequate thickness, and the heat of the glass ribbon is utilized to thermally decompose the raw material gas and deposit the transparent conductive film (in the following this film deposition method is referred to as "online CVD").

In online CVD, a thermal decomposition reaction of the tin raw material advances at the surface of the glass ribbon, which has a temperature from the molten state to near the glass transition temperature (roughly 750 to 560°C). This thermal decomposition reaction advances by utilizing the heat of the glass ribbon, so that if inorganic tin raw material is used, the thermal decomposition reaction occurs at an early stage, and the crystal growth of the tin oxide advances locally. As a result, giant crystal grains of tin oxide will be deposited at the surface of the transparent conductive film. Incidentally, rather than being completely flat, it is preferable that there is a roughness of a fraction of the wavelength of visible light in the surface of the transparent conductive film. By forming such a roughness in the surface of the transparent conductive film, transmitted light is scattered at the border surface of the transparent conductive film and the photoelectric conversion layer, and a so-called light-confining effect can be attained, in which the optical path length in the photoelectric conversion layer becomes long. Or, the photoelectric conversion layer is formed complementarily to the surface roughness in the transparent conductive film, and the so-called anchor effect works, which has the advantage of increasing their bonding strength. However on the other hand, if giant crystal grains are formed in the surface of the transparent conductive film, then it becomes difficult to form the photoelectric conversion layer uniformly, and moreover, the giant crystal grains may penetrate the photoelectric conversion layer and reach the rear electrodes, causing a short circuit in the photoelectric conversion device. Consequently, in online CVD, in order to use inorganic tin raw material, it is necessary to employ some means to ensure that no giant crystal grains are formed in the transparent conductive film surface.

As such a preventive means, it is conceivable to carry out the film deposition at a location where the temperature of the glass ribbon is lower, such as in the annealing furnace 13, or to set a lower concentration of the raw material gas, but if these means are employed, thermal relaxation after the film deposition becomes difficult, because the film deposition takes place after the glass has hardened, so that the bonding strength of the transparent conductive film may decrease or it may be necessary to slow down the line speed of the glass ribbon in order to deposit the transparent conductive film uniformly, which means that this approach is not necessarily advantageous in an actual industrial setting. Therefore, conventionally these problems are solved by using an organic tin raw material with relatively low reactivity, and as the flip-side of this, carbon remained in the transparent conductive film.

EP-A2-0983972 relates to solar-control glass having a solar energy (NIR) absorbing layer comprising tin oxide and a low emissivity control layer. In one example a gas containing 0.5 mol% of organotin is used to deposit a ≈240 nm thick layer of antimony doped tin in ≈6.1 secs, which forms the NIR layer. A separate anti-iridescence underlayer is not needed.

The present invention was conceived by focusing on these problems. It is an object of the present invention to present a method for forming a transparent conductive film whose principal component is tin oxide by CVD on a glass ribbon, preventing the generation of giant crystal grains in the tin oxide, while ensuring that the concentration of carbon is low, or in other words, the absorption coefficient at 400 to 550 nm wavelength is low. It is another object of the present invention to present a photoelectric conversion device without defects, such as short circuits, and which can display a high photoelectric conversion efficiency, due to using a glass substrate provided with this transparent conductive film.

Accordingly, the present invention provides a glass substrate with a transparent conductive film, consisting of: a glass substrate, a transparent conductive film whose principal component is tin oxide and an undercoating film formed between the glass substrate and the transparent conductive film, the undercoating film being a single layer that includes silica as a principle component or multiple layers that consist of a first undercoating layer including tin oxide as a principal component and formed on the glass substrate side and a second undercoating layer including silica as a principal component and formed on the transparent conductive film side; wherein the glass substrate with a transparent conductive film is obtained by a method that comprises: depositing the transparent conductive film on a glass ribbon in a float process using a raw material gas that includes 0.5 to 2.0 mol% of an organic tin compound, at least 10 mol% of an oxidation raw material, and a fluorine raw material, the temperature of the glass ribbon being 560°C to 750°C during the deposition of the transparent conductive film, the film deposition speed of the transparent conductive film being 3000 to 7000 nm/min; and cutting the glass ribbon to obtain the glass substrate with a transparent conductive film; wherein the transparent conductive film includes a component reducing the sheet resistance of the transparent conductive film, and the component consists of fluorine derived from the fluorine raw material, and the concentration of fluorine in the transparent conductive film is 0.03 to 0.1 wt%; wherein the transparent conductive film has a thickness of 400 to 1000 nm; wherein a ratio of the number of carbon atoms to the number of tin atoms in the transparent conductive film is smaller than 4x10⁻³; and wherein an absorption coefficient at 400 to 550 nm wavelength of the transparent conductive film is not greater than 0.40x10³ cm⁻¹.

The present invention further presents a photoelectric conversion device comprising the above described glass substrate.

Preferred embodiments of the present invention will now be described by way of example only and with reference to the accompanying drawing, in which:
Fig. 1 is a schematic diagram showing an apparatus used for online CVD.

The present invention is based on the premise that for the formation of transparent conductive thin films whose principal component is tin oxide, by online CVD, an organic tin compound is used as the tin raw material, and relates to a film deposition method in which the amount of carbon remaining in the transparent conductive film is reduced. As a result of detailed studies of the film deposition conditions when using organic tin raw materials, the inventors have focused on the relation between the concentration of the tin raw material in the raw material gas and the film deposition speed, and have found that within a certain range, the concentration of carbon in the transparent conductive film is much lower than in the related art. More specifically, this is the case if the concentration of organic tin compounds in the raw material gas is 0.5 to 2.0 mol% and the film deposition speed is 3000 to 7000 nm/min, preferably 3000 to 5500 nm/min.

It should be noted that throughout this specification, "principal component" is used in its prevalent meaning, namely a component whose weight content is at least 50 wt%.

The main factors affecting the film deposition speed of the transparent conductive film are the concentration of the tin material and the temperature of the glass ribbon. Other factors include for example the type and concentration of oxidation raw material, such as oxygen, ozone, water vapor or the like, as well as the presence of reaction inhibitors such as hydrogen bromide, but these are not the main factors. The relation between the film deposition speed on the one hand and the concentration of the tin raw material and the glass ribbon temperature on the other hand is usually such that when the concentration of the tin raw material and the temperature of the glass ribbon become higher, the film deposition speed becomes higher as well, whereas when the concentration of the tin raw material and the temperature of the glass ribbon become lower, then the film deposition speed becomes lower as well. The film deposition speed in online CVD must correspond to the line speed of the glass ribbon, that is, the speed at which the glass ribbon is pulled from the annealing furnace 13, and the film deposition conditions that are set in consideration of this line speed are in the above-noted range.

At an organic tin compound concentration of less than 0.5 mol%, the film deposition speed is less than 500 nm/min, even if the temperature of the glass ribbon is 750°C, and the film deposition speed cannot keep up with the line speed of a glass ribbon with a thickness of 5 mm or less in actual industrial processes, so that there is the problem that a transparent conductive film of the desired thickness cannot be formed. On the other hand, if the concentration exceeds 2.0 mol%, the carbon concentration in the transparent conductive film becomes high, and the film will be like a conventional transparent conductive film.

Particularly preferable as the organic tin compound are dimethyltin dichloride or monobutyltin trichloride. These may be used alone or in combination. Moreover, if 70% or more of at least one selected from dimethyltin dichloride or monobutyltin trichloride is contained, then it can be used preferably as the organic tin compound of the present invention. The reactivity of dimethyltin dichloride and monobutyltin trichloride in the film deposition temperature range for online CVD is not very high, so that by using them, a uniform thin film can be formed over a large surface area. Moreover, they have the advantage that they are easy to obtain and inexpensive, and compared to other organic tin raw materials, have low volatility and are easy to store.

If dimethyltin dichloride is used, it is furthermore preferable to set the concentration to 1.0 to 2.0 mol% and the film deposition speed to 4000 to 6000 nm/min. On the other hand, if monobutyltin trichloride is used, it is preferable to set the concentration to 1.5 to 2.0 mol% and the film deposition speed to 4000 to 6000 nm/min.

In the transparent conductive film formed with this film deposition method, the ratio of the number of carbon atoms to the number of tin atoms (C/Sn) is less than 4×10⁻³, and as a result, the absorption coefficient at wavelength of 400 to 550 nm is not greater than 0.40×10³ cm⁻¹. Moreover, with these preferable film deposition conditions, the ratio of the number of carbon atoms to the number of tin atoms can be reliably decreased to 3×10⁻³ or less, and the absorption coefficient at wavelength of 400 to 550 nm can be reliably decreased to 0.30×10³ cm⁻¹ or less. Here, the absorption coefficient is the coefficient k cm⁻¹ in the equation I=I₀•e^{-kd}, wherein I₀ is the intensity of light that is incident on the thin film and I is the intensity of light that has advanced for a distance of d cm in the thin film direction.

In online CVD, because the inside of the shaping bath is filled with non-oxidizing gas such as nitrogen and hydrogen, the above-noted tin raw materials undergo a thermal decomposition reaction with the oxidation raw material included in the raw material gas. Examples of the oxidation raw material are oxygen, ozone, water vapor and dry air. The oxidation raw material fulfills the function of lowering the carbon concentration in the transparent conductive film, so that it is preferable that it is contained at 10 mol%, more preferably 15 mol% or more in the raw material gas.

Moreover, in order to reduce the sheet resistance of the transparent conductive film, a fluorine raw material is added to the raw material gas. Examples of fluorine raw materials are hydrogen fluoride, trifluoroacetic acid, bromotrifluoromethane, chlorodifluoromethane and the like. It is preferable that the concentration of the fluorine raw material is 0.1 to 1.0 mol%. A suitable carrier gas for transporting these raw materials to the surface of the glass ribbon is nitrogen. Nitrogen is a component that is also present in the gas atmosphere inside the shaping bath, so that it does not affect the properties of the gas atmosphere if it leaks from the coaters.

The fluorine concentration in the transparent conductive film is 0.03 to 0.1 wt%, more preferably not greater than 0.08 wt% and at least 0.05 wt%. If the fluorine concentration is too high, the absorption coefficient of the transparent conductive film becomes too large. On the other hand, if the fluorine concentration is too low, the specific resistance of the conductive film becomes too large.

If a large amount of alkali components is contained in the glass ribbon, then it is better to provide an undercoating layer before depositing the transparent conductive film. It is known that alkali components thermally diffuse into the transparent conductive film during the film deposition stage, and diffuse over time even after the film deposition. This diffusion of alkali components reduces the conductivity of the transparent conductive film. In order to address this, with the purpose of preventing the diffusion of alkali components, an undercoating film is disposed between the glass ribbon and the transparent conductive film, whose principal component is silica (SiO₂). The thickness of the undercoating film is preferably 5 to 100 nm. To function as an undercoating film, a thickness of 5 nm is necessary, whereas in excess of 100 nm, the decrease of visible light transmittance becomes noticeable.

The undercoating film is not limited to a single layer, but may consist of multiple layers. In the case of multiple layers, a preferable configuration has a first undercoating layer whose principal component is for example tin oxide formed on the glass ribbon side, and a second undercoating layer whose principal component is silica. It should be noted that also in the case of multiple layers, it is preferable that the total thickness of the undercoating film is not greater than 100 nm.

The undercoating film is formed by online CVD in the same manner as the transparent conductive film. It is possible to use monosilane. disilane. trisilane, monochlorosilane, dichlorosilane, 1,2-dimethylsilane, 1,1,2-trimethyldisilane, 1,1,2,2,-tetramethyldisilane, tetramethylorthosilicate, or tetraethylortho- silicate for example as the silicon raw material. Suitable examples of the oxidation raw material for this case include oxygen, water vapor, dry air, nitrogen dioxide, and ozone. In the case of an undercoating film whose principal component is aluminum oxide, it is possible to use trimethylaluminum, aluminum triisopropoxide, diethylaluminum chloride, aluminum acetylacetonate or aluminum chloride for example as the aluminum raw material. Examples of suitable oxidation raw materials for this case include oxygen, water vapor and dry air.

The transparent conductive film may also include silicon, aluminum, zinc, copper, indium, bismuth, gallium, boron, vanadium, manganese, or zirconium. However, it is preferable that the concentration of these trace components other than fluorine is not greater than 0.02 wt%. However, since chlorine is included in form of the organic zinc compound as noted above, its concentration in the transparent conductive film becomes relatively high. For this reason, the concentration of chlorine should be not greater than 0.15 wt%, or preferably not greater than 0.10 wt%.

The sheet resistance of the conductive film is preferably 5 to 40 Ω/□ (square), and more preferably not greater than 30 Ω/□. In consideration of this preferable region of sheet resistance, the film thickness of the transparent conductive film is 400 to 1000 nm.

The online CVD process can be implemented using the apparatus shown in Fig. 1. The apparatus shown in Fig. 1 is provided with three coaters 16a, 16b and 16c as the coaters 16, but the number of coaters is not limited to this. A glass ribbon 10 whose top face (that is, the face opposite from the bottom face, which contacts the molten tin 5) is provided with a film made of one or a plurality of layers made from the raw material supplied by the coaters 16 is lifted by a roll 17 to an annealing furnace 13, and after annealing, is cut further downstream to a predetermined shape.

The glass substrate provided with this transparent conductive film can be utilized for photoelectric conversion devices, such as solar cells. The photoelectric conversion devices have at least one photoelectric conversion unit and a rear electrode formed in that order on the transparent conductive film. In the photoelectric conversion devices, the glass substrate side is used as the side on which light is incident.

The photoelectric conversion unit may include a single layer, or it may include multiple layers. Examples of suitable photoelectric conversion units include units in which an amorphous silicon thin film or a crystalline silicon thin film serves as the photoelectric conversion layer (in the following, such units are referred to by indicating the type of the photoelectric conversion layer, such as "amorphous silicon thin-film photoelectric conversion units" and "crystalline silicon thin-film photoelectric conversion units").

Amorphous silicon thin-film photoelectric conversion units are formed by depositing p-i-n semiconductor layers in that order by plasma CVD. More specifically, a p-type microcrystalline silicon layer doped with at least 0.01 atom% of boron impurities determining conductivity, an intrinsic amorphous silicon layer serving as the photoelectric conversion layer, and an n-type microcrystalline silicon layer doped with at least 0.01% of phosphorus impurities determining conductivity are deposited in that order. However, there is no limitation to these layers, and it is also possible to take for example aluminum as the impurity atoms in the p-type microcrystalline silicon layer, or to use an amorphous silicon layer as the p-type layer. It is also possible to use amorphous or microcrystalline silicon carbide, or an alloy such as silicon-germanium as the p-type layer.

It should be noted that the film thickness of the conductive (p- and n-type) microcrystalline silicon layers is preferably 3 to 100 nm, and more preferably 5 to 50 nm.

It is preferable that the intrinsic amorphous silicon layer is deposited by plasma CVD at not more than 450°C. This layer is formed as a thin film of a substantially intrinsic semiconductor, in which the density of the conductivity-determining impurity atoms is not greater than 1×10¹⁸ cm⁻³. It is preferable that the film thickness of the intrinsic amorphous silicon layer is 0.05 to 0.5 µm. However, in amorphous silicon thin-film photoelectric conversion units, it is also possible to use alloy materials, such as an amorphous silicon carbide layer (for example an amorphous silicon carbide layer made of amorphous silicon containing not more than 10 atom% of carbon) or an amorphous silicon-germanium layer (for example an amorphous silicon-germanium layer made of amorphous silicon containing not more than 30 atom% of germanium), instead of the intrinsic amorphous silicon layer.

Like amorphous silicon thin-film photoelectric conversion units, also crystalline silicon thin-film photoelectric conversion units are made by depositing, by plasma CVD, p-i-n semiconductor layers in that order.

For the rear electrode, it is preferable to form at least one metal layer made of at least one metal selected from aluminum, silver, gold, copper, platinum and chromium by sputtering or vapor deposition. It is also possible to dispose a conductive oxide such as ITO, tin oxide, zinc oxide or the like between the photoelectric conversion units and the metal electrode.

It is preferable that this photoelectric conversion device includes crystalline silicon thin-film photoelectric conversion units. By including such units, the open-circuit voltage that is generated is lower and the generated short-circuit current density is higher than with amorphous silicon thin-film photoelectric conversion units, so that the optical transmittance of the transparent conductive film contributes more to the photoelectric conversion efficiency than its sheet resistance.

### Working Examples

The following is a more detailed description of the present invention with reference to working examples.

First, the following is an explanation of a method for measuring/calculating the absorption coefficient of the transparent conductive film, the component concentrations of carbon and fluorine etc. in the transparent conductive film, and the ratio between the number of tin atoms and the number of carbon atoms in the transparent conductive film.

### Absorption Coefficient of the Transparent Conductive Film

Methylene iodide with a refractive index of 1.79 was applied onto the transparent conductive film formed on an undercoating thin film, and a cover glass (#7059 by Corning Inc.) of 1 mm thickness was placed directly thereon, thus fabricating a sample in which the scattering loss due to the surface roughness of the conductive film is eliminated. The transmittance and reflectance of these samples at 400 to 550 nm were measured with a spectrophotometer, and the absorbance was determined from the results. On the other hand, methylene iodide was applied on an undercoating thin film of a glass substrate not provided with a transparent conductive film, and a cover glass was placed directly thereon to fabricate a reference sample, and the absorbance of the reference sample was determined in the same manner as described above. The absorption coefficient of the transparent conductive film was determined by subtracting the absorbance of the reference sample from the absorbance of the sample and solving the equations including terms for multiple reflections.

### Component Concentrations in the Transparent Conductive Film

The fluorine concentration and the chlorine concentration were calculated from the characteristic X-ray intensities of an electron microanalyzer.

### Ratio Between the Number of Tin Atoms and the Number of Carbon Atoms (C/Sn) in the Transparent Conductive Film

The ratio of the number of carbon atoms to the number of tin atoms was determined by X-ray photoelectron spectrometry from the atom concentration (%) calculated from the relative sensitivity coefficient from the peak area of Sn3d5/2 and C1s.

In the following working examples and comparative examples, an undercoating film whose principal component is silica and a transparent conductive film whose principal component is tin oxide doped with fluorine were deposited on a glass ribbon of 5 mm thickness by online CVD using the apparatus shown in Fig. 1. Inside the shaping bath, a non-oxidizing gas mixture of 98 vol% nitrogen and 2 vol% hydrogen was constantly supplied at a pressure that was slightly higher than the external pressure. Moreover, a soda-lime-silica glass, which contains a large quantity of alkali components, was used for the glass ribbon. After the glass ribbon was hardened in the annealing furnace, it was cut to a predetermined size using a cutting device (not shown in the drawings) arranged further downstream. The following is a more detailed explanation of the film deposition conditions.

### Working Example 1

A gas mixture made of monosilane, ethylene, oxygen and nitrogen was supplied from the coater positioned furthest to the upstream side, and an undercoating film with about 30 nm film thickness whose principal component is silica was deposited on the glass ribbon. Subsequently, a gas mixture obtained by mixing a nitrogen carrier gas such that it contains 1.9 mol% dimethyltin dichloride (vapor), 36 mol% oxygen, 33 mol% water vapor, 5 mol% helium and 0.5 mol% hydrogen fluoride was supplied from a coater further downstream and a transparent conductive film of about 700 nm thickness whose principal component is tin oxide doped with fluorine was deposited at a film deposition speed of 5000 nm/min. The surface temperature of the glass ribbon just before depositing the transparent conductive film was about 650°C.

The film deposition conditions and the properties of this transparent conductive film are listed in Table 1 and Table 2.

### Working Example 2

The concentration of the dimethyltin dichloride, the film deposition speed and the surface temperature of the glass ribbon just before depositing the transparent conductive film in Working Example 1 were changed as shown in Table 1, but otherwise the undercoating film and the transparent conductive film were deposited in the same manner as in Working Example 1.

The film deposition conditions and the properties of this transparent conductive film are listed in Table 1 and Table 2.

### Working Example 3

Monobutyltin trichloride was used instead of the dimethyltin dichloride, and the film deposition speed and the surface temperature of the glass ribbon just before depositing the transparent conductive film in Working Example 1 were changed as shown in Table 1, but otherwise the undercoating film and the transparent conductive film were deposited in the same manner as in Working Example 1.

The film deposition conditions and the properties of this transparent conductive film are listed in Table 1 and Table 2.

### Comparative Examples 1 to 3

The concentration of the dimethyltin dichloride, the film deposition speed and the surface temperature of the glass ribbon just before depositing the transparent conductive film in Working Example 1 were changed as shown in Table 1, but otherwise the undercoating film and the transparent conductive film were deposited in the same manner as in Working Example 1.

The film deposition conditions and the properties of these transparent conductive films are listed in Table 1 and Table 2.

**Table 1: Film Deposition Conditions**

| | tin raw material | tin raw mat. concentr. (mol%) | glass temp. during film deposi. (°C) | film deposition speed (nm/min) |
|---|---|---|---|---|
| Working Ex. 1 | DMT | 1.9 | 650 | 5000 |
| Working Ex. 2 | DMT | 1.8 | 640 | 4500 |
| Working Ex. 3 | MBTC | 1.9 | 660 | 5500 |
| Comp. Ex. 1 | DMT | 2.7 | 650 | 6200 |
| Comp. Ex. 2 | DMT | 2.5 | 640 | 5800 |
| Comp. Ex. 3 | DMT | 3.7 | 660 | 7500 |

| | | | | |
|---|---|---|---|---|
| DMT = dimthyltin dichloride; MBTC = monobutyltin trichloride | | | | |

**Table 2: Properties of Transparent Conductive Film**

| | fluorine concentr. (wt%) | chlorine concentr. (wt%) | C/Sn (ratio of atom numbers) | absorption coeff. (10³ cm⁻¹) | | sheet resistance (Ω/□) |
|---|---|---|---|---|---|---|
| | | | | 400 nm | 500 nm | |
| Working Ex. 1 | 0.07 | 0.05 | 0.002 | 0.38 | 0.35 | 9.5 |
| Working Ex. 2 | 0.07 | 0.05 | 0.002 | 0.37 | 0.35 | 9.5 |
| Working Ex. 3 | 0.07 | 0.06 | 0.003 | 0.39 | 0.36 | 9.4 |
| Comp. Ex. 1 | 0.07 | 0.05 | 0.006 | 0.64 | 0.54 | 8.8 |
| Comp. Ex. 2 | 0.06 | 0.04 | 0.005 | 0.61 | 0.50 | 13.8 |
| Comp. Ex. 3 | 0.06 | 0.05 | 0.008 | 0.87 | 0.61 | 12.3 |

Looking at the Working Examples 1 to 3 and the Comparative Examples 1 to 3 in general, it can be seen that the film deposition speed, the ratio of the number of carbon atoms to the number of tin atoms in the transparent conductive film and the absorption coefficient at 400 nm wavelength and at 500 nm wavelength increase in correspondence with the organic tin compound concentration. Moreover, it can be seen that in the Comparative Examples 1 to 3, in which the concentration of the organic tin compound exceeds 2 mol%, the absorption coefficient is about the same as in conventional transparent conductive films.

Furthermore, layered thin-film photoelectric conversion devices were fabricated in which amorphous silicon photoelectric conversion units and crystalline silicon photoelectric conversion units were formed in that order on the glass/transparent conductive film formed in Working Examples 1 and 2 and in Comparative Examples 1 and 2.

The following is an explanation of the procedure of this fabrication method. First, using a plasma CVD apparatus, an amorphous silicon photoelectric conversion unit with a total thickness of 300 nm made of an amorphous p-type silicon carbide layer, an undoped amorphous i-type silicon photoelectric conversion layer and an n-type silicon layer was formed in that order on the above-described transparent conductive film. Then, a p-type crystalline silicon layer, an i-type silicon photoelectric conversion layer and an n-type silicon layer were deposited in that order, thus forming a crystalline silicon photoelectric conversion unit with a total thickness of 1.5 µm. Furthermore, a zinc oxide film of 90 nm thickness and an Ag film of 200 nm thickness were formed by sputtering as the rear-side metal electrode. Next, a layered thin-film photoelectric conversion device of 1 by 1 cm square was fabricated by eliminating the photoelectric unit and the metal rear-side electrode along the periphery with a YAG SHG pulsed laser, but leaving the transparent conductive film. Table 3 lists the resulting solar cell properties at a measurement temperature of 25°C under artificial sunlight of AM 1.5 and 1 kW/m².

**Table 3: Solar Cell Properties**

| | open-circuit voltage | short-circuit current density | fill factor | conversion efficiency |
|---|---|---|---|---|
| Working Ex. 1 | 1.00 | 1.03 | 1.00 | 1.03 |
| Working Ex. 1 | 1.00 | 1.03 | 1.00 | 1.03 |
| Comp. Ex. 1 | 1.00 | 1.00 | 1.00 | 1.00 |
| Comp. Ex. 2 | 1.00 | 1.00 | 0.98 | 0.98 |

Note that the parameters of the solar cell properties have been normalized using the values in Comparative Example 1. Moreover, with the above-described film thickness configuration, the short-circuit current of the photoelectric devices is limited by the short-circuit current that is obtained on the side of the amorphous silicon photoelectric conversion unit.

Looking at the properties of the photoelectric conversion devices, the short-circuit current density on the amorphous photoelectric conversion unit side of the working examples is 3% higher than that of the comparative examples, which reflects that the working examples have an absorption coefficient at 400 to 500 nm wavelength, which is the optical absorption region of the amorphous photoelectric conversion units, that is only about half that of the comparative examples.

Due to the above configuration, the present invention displays the following effects.

With the method for depositing a transparent conductive film according to the present invention, the film deposition speed can be kept down by using an organic tin compound as the tin raw material in online CVD and controlling its concentration. The transparent conductive film formed as the result has no giant crystal grains, has a low carbon content and a high transmittance of visible light, so that it can be utilized for photoelectric conversion devices. Furthermore, a photoelectric conversion device utilizing a glass substrate provided with this transparent conductive film has no defects, such as short circuits, and can display a high photoelectric conversion efficiency.

## Claims

1. A glass substrate with a transparent conductive film, consisting of:
a glass substrate, a transparent conductive film whose principal component is tin oxide and an undercoating film formed between the glass substrate and the transparent conductive film, the undercoating film being a single layer that includes silica as a principle component or multiple layers that consist of a first undercoating layer including tin oxide as a principal component and formed on the glass substrate side and a second undercoating layer including silica as a principal component and formed on the transparent conductive film side;
wherein the glass substrate with a transparent conductive film is obtained by a method that comprises:
depositing the transparent conductive film on a glass ribbon in a float process using a raw material gas that includes 0.5 to 2.0 mol% of an organic tin compound, at least 10 mol% of an oxidation raw material, and a fluorine raw material, the temperature of the glass ribbon being 560°C to 750°C during the deposition of the transparent conductive film, the film deposition speed of the transparent conductive film being 3000 to 7000 nm/min; and
cutting the glass ribbon to obtain the glass substrate with a transparent conductive film;
wherein the transparent conductive film includes a component reducing the sheet resistance of the transparent conductive film, and the component consists of fluorine derived from the fluorine raw material, and the concentration of fluorine in the transparent conductive film is 0.03 to 0.1 wt%;
wherein the transparent conductive film has a thickness of 400 to 1000 nm;
wherein a ratio of the number of carbon atoms to the number of tin atoms in the transparent conductive film is smaller than 4x10⁻³; and
wherein an absorption coefficient at 400 to 550 nm wavelength of the transparent conductive film is not greater than 0.40x10³ cm⁻¹.

2. A photoelectric conversion device comprising a glass substrate as claimed in claim 1.

## Patentansprüche

1. Glassubstrat mit einem transparenten leitfähigen Film bestehend aus:
einem Glassubstrat, einem transparenten leitfähigen Film, dessen Hauptbestandteil Zinnoxid ist, und einem Unterschichtfilm, welcher zwischen dem Glassubstrat und dem transparenten leitfähigen Film ausgebildet ist, wobei der Unterschichtfilm eine einzelne Schicht ist, die Silica als Hauptkomponente beinhaltet, oder mehrere Schichten ist, die aus einer ersten Unterschicht, die Zinnoxid als Hauptkomponente beinhaltet und auf der Glassubstratseite ausgebildet ist, und einer zweiten Unterschicht, die Silica als Hauptkomponente beinhaltet und auf der Seite des transparenten leitfähigen Films ausgebildet ist, besteht,
wobei das Glassubtrat mit einem transparenten leitfähigen Film gemäß einem Verfahren erhalten wird, welches umfasst:
Abscheiden des transparenten leitfähigen Films auf einem Glasband in einem Floatverfahren unter Verwendung eines Rohmaterialgases, welches 0,5 bis 2,0 Mol-% einer organischen Zinnverbindung, wenigstens 10 Mol-% eines Oxidationsrohmaterials und eines Fluorrohmaterials beinhaltet, wobei die Temperatur des Glasbandes während dem Abscheiden des transparenten leitfähigen Films 560 °C bis 750 °C ist, wobei die Filmabscheidungsgeschwindigkeit des transparenten leitfähigen Films 3000 bis 7000 nm/min ist; und
Schneiden des Glasbandes, um das Glassubstrat mit einem transparenten leitfähigen Film zu erhalten;
wobei der transparente leitfähige Film eine Komponente beinhaltet, die den Schichtwiderstand des transparenten leitfähigen Films verringert, und die Komponente aus Fluor besteht, das von dem Fluorrohmaterial abgeleitet ist, und die Fluorkonzentration in dem transparenten leitfähigen Film 0,03 bis 0,1 Gew.-% ist;
wobei der transparente leitfähige Film eine Dicke von 400 bis 1000 nm aufweist;
wobei ein Verhältnis der Anzahl von Kohlenstoffatomen zu der Anzahl von Zinnatomen in dem transparenten leitfähigen Film kleiner als 4 x 10⁻³ ist; und
wobei ein Absorptionskoeffizient bei 400 bis 550 nm Wellenlänge des transparenten leitfähigen Films nicht größer als 0,40 x 10⁻³ cm⁻¹ ist.

2. Eine photoelektrische Konversionsvorrichtung umfassend ein Glassubstrat gemäß Anspruch 1.

## Revendications

1. Substrat de verre ayant un film conducteur transparent, constitué :
d'un substrat de verre, d'un film conducteur transparent dont le composant principal est l'oxyde d'étain et d'un film de sous-couche formé entre le substrat de verre et le film conducteur transparent, le film de sous-couche étant une monocouche qui contient de la silice en tant que composant principal ou de multiples couches constituées d'une première couche de sous-couche contenant de l'oxyde d'étain en tant que composant principal et formée du côté du substrat de verre et d'une seconde couche de sous-couche contenant de la silice en tant que composant principal et formée du côté du film conducteur transparent ;
dans lequel le substrat de verre ayant un film conducteur transparent est obtenu par un procédé qui comprend :
le dépôt du film conducteur transparent sur un ruban de verre dans un procédé de flottage en utilisant une matière première gazeuse qui contient 0,5 à 2,0 % en mole d'un composé d'étain organique, au moins 10 % en mole d'une matière première d'oxydation, et une matière première fluorée, la température du ruban de verre étant de 560 °C à 750 °C pendant le dépôt du film conducteur transparent, la vitesse de dépôt de film du film conducteur transparent étant de 3000 à 7000 nm/minute ; et
la découpe du ruban de verre pour obtenir le substrat de verre ayant un fil conducteur transparent ;
dans lequel le film conducteur transparent comprend un composant réduisant la résistance de couche du film conducteur transparent, et le composant consiste en du fluor dérivé de la matière première fluorée, et la concentration en fluor dans le film conducteur transparent est de 0,03 à 0,1 % en poids ;
dans lequel le film conducteur transparent possède une épaisseur de 400 à 1000 nm ;
dans lequel un rapport entre le nombre d'atomes de carbone et le nombre d'atomes d'étain dans le film conducteur transparent est inférieur à 4 x 10⁻³ ; et
dans lequel un coefficient d'absorption à une longueur d'onde de 400 à 550 nm du film conducteur transparent n'est pas supérieur à 0,40 x 10³ cm⁻¹.

2. Dispositif de conversion photoélectrique comprenant un substrat de verre selon la revendication 1.
